(19)

Europäisches
Patentamt
European
Patent Office
Office européen
des brevets

(11)  **EP 4 282 906 A1**

(12)  **EUROPEAN PATENT APPLICATION**
published in accordance with Art. 153(4) EPC

(43) Date of publication:
    **29.11.2023 Bulletin 2023/48**

(21) Application number: **22742646.7**

(22) Date of filing: **20.01.2022**

(51) International Patent Classification (IPC):
    **C08J 5/18** (2006.01)     **B32B 15/01** (2006.01)
    **B32B 15/08** (2006.01)    **B32B 15/082** (2006.01)
    **H05K 1/03** (2006.01)     **C08J 7/00** (2006.01)

(52) Cooperative Patent Classification (CPC):
    **B32B 15/01; B32B 15/08; B32B 15/082;**
    **C08J 5/18; C08J 7/00; C08J 7/18; H05K 1/03**

(86) International application number:
    **PCT/JP2022/001979**

(87) International publication number:
    **WO 2022/158524 (28.07.2022 Gazette 2022/30)**

(84) Designated Contracting States:
    **AL AT BE BG CH CY CZ DE DK EE ES FI FR GB
    GR HR HU IE IS IT LI LT LU LV MC MK MT NL NO
    PL PT RO RS SE SI SK SM TR**
    Designated Extension States:
    **BA ME**
    Designated Validation States:
    **KH MA MD TN**

(30) Priority: **20.01.2021  JP 2021007172
                19.03.2021  JP 2021045749**

(71) Applicant: **Daikin Industries, Ltd.
    Osaka-shi, Osaka 530-0001 (JP)**

(72) Inventors:
    • **KOMORI, Hirokazu
      Osaka-shi, Osaka 530-0001 (JP)**

    • **HIGUCHI, Tatsuya
      Osaka-shi, Osaka 530-0001 (JP)**
    • **TAKAHASHI, Kenzo
      Osaka-shi, Osaka 530-0001 (JP)**
    • **KAWAMURA, Masahiko
      Osaka-shi, Osaka 530-0001 (JP)**
    • **YOKOTANI, Koji
      Osaka-shi, Osaka 530-0001 (JP)**
    • **TERADA, Junpei
      Osaka-shi, Osaka 530-0001 (JP)**
    • **KOMATSU, Nobuyuki
      Osaka-shi, Osaka 530-0001 (JP)**

(74) Representative: **Hoffmann Eitle
    Patent- und Rechtsanwälte PartmbB
    Arabellastraße 30
    81925 München (DE)**

(54)  **FLUORORESIN FILM, COPPER-CLAD LAMINATE AND SUBSTRATE FOR CIRCUITS**

(57)  Provided are a fluororesin film with few defects in lamination and highly adhesive to copper foil, and a copper-clad laminate using the same. A fluororesin film that is a film including a fluorine-containing composition, wherein the oxygen element percentage as measured when heat treatment is performed at 180°C for 3 minutes and then the state of one or both surfaces of the film is observed by scanning X-ray photoelectron spectroscopy (XPS/ESCA) is 1.35 atom% or more, and an absolute value of the rate of dimensional change in MD and TD before and after heat treatment as measured when the film is heat-treated at 180°C for 10 minutes and then cooled to room temperature is 2% or less.

**EP 4 282 906 A1**

## Description

Technical Field

The present disclosure relates to a fluororesin film, a copper-clad laminate and a substrate for circuits.

Background Art

Epoxy resin and polyimide resin have been widely used for circuit boards as an insulation layer. In recent years, for high frequency circuit boards used for applications in a high frequency region of a few tens of GHz, structures in which an insulation layer made of fluororesin is formed on copper foil have been proposed in consideration of dielectric properties and hygroscopic properties (Patent Literatures 1 to 3).

For such printed wiring boards, fluororesin film has been surface-treated to provide adhesion to copper foil (Patent Literature 1).

Citation List

Patent Literature

Patent Literature 1: International Publication No. 2016/021666
Patent Literature 2: International Publication No. 2019/203243
Patent Literature 3: International Publication No. 2020/145133

Summary of Invention

Technical Problem

An object of the present disclosure is to provide a fluororesin film with few defects in lamination and highly adhesive to copper foil, and a copper-clad laminate using the same.

Solution to Problem

The present disclosure includes:

A fluororesin film that is a film comprising a fluororesin-containing composition,
wherein an oxygen element percentage as measured when heat treatment is performed at 180°C for 3 minutes and then the state of one or both surfaces of the film is observed by scanning X-ray photoelectron spectroscopy (XPS/ESCA) is 1.35 atom% or more, and
an absolute value of a rate of dimensional change in MD and TD before and after heat treatment as measured when the film is heat-treated at 180°C for 10 minutes and then cooled to 25°C is 2% or less.

It is preferable that the oxygen element percentage is 1.5 atom% or more. It is preferable that the fluororesin film comprises tetrafluoroethylene-perfluoroalkyl vinyl ether (PFA) or tetrafluoroethylene-hexafluoropropylene (FEP).

It is preferable that, in the fluororesin film, a difference between an oxygen element percentage measured when the state of one or both surfaces of the film is observed by scanning X-ray photoelectron spectroscopy (XPS/ESCA) and an oxygen element percentage measured by scanning X-ray photoelectron spectroscopy (XPS/ESCA) after etching the film by argon gas cluster ion beams at an incident angle of 45° in the direction of the depth for 15 minutes is 1.0 atom% or more.

It is preferable that one or both surfaces of the above fluororesin film have an adhesion strength of more than 30 N/m when the surfaces of the film are mutually bonded at 200°C.

It is preferable that the above fluororesin film has a dielectric loss tangent at 10 GHz of less than 0.0015.

It is preferable that the above fluororesin film has a dielectric loss tangent at 40 GHz of less than 0.0015.

It is preferable that, in the above fluororesin film, the number of unstable terminal groups is less than 10 per $10^6$ carbon atoms in a main chain of the fluororesin.

It is preferable that the above fluororesin film has an adhesion strength of 0.8 N/mm or more when bonded to copper foil having a surface roughness Rz of 1.5 $\mu$m or less.

It is preferable that the above fluororesin film is used for a copper-clad laminated board.

The present disclosure also includes a copper-clad laminate comprising copper foil and any of the fluororesin films described above as essential layers.

It is preferable that the above copper-clad laminate further comprises another layer in addition to the copper foil and the fluororesin film. It is preferable that the other layer in addition to the copper foil and the fluororesin film is at least one selected from the group consisting of polyimide, liquid crystal polymer, polyphenylene sulfide, a cycloolefin polymer, polystyrene, epoxy resin, bismaleimide, polyphenylene oxide, polyphenylene ether and polybutadiene.

It is preferable that the copper foil has a surface roughness Rz of 1.5 μm or less.

It is preferable that the above copper-clad laminated board has an adhesion strength between the copper foil and the fluororesin film of 0.8 N/mm or more.

The present disclosure also includes a substrate for circuit comprising any of the copper-clad laminate described above.

The present disclosure also relates to a method for producing any of the copper-clad laminate described above, comprising preheating a fluororesin film at the glass transition temperature or more and less than the melting point of the film, and then bonding the film to copper foil and/or a substrate other than the copper foil or the fluororesin.

Advantageous Effect of Invention

The fluororesin film of the present disclosure has the advantageous effect of few defects in lamination and being capable of providing excellent adhesion to copper foil.

Description of Embodiments

Hereinafter the present disclosure will be described in more detail.

When a copper-clad laminated board is produced by laminating fluororesin film and copper foil by a roll-to-roll method, it is required to reduce defects in the lamination step and to achieve high adhesiveness between fluororesin and copper foil.

One of the causes of defects in the lamination step is that film which has wrinkles (spoking) is stacked with wrinkles remaining when laminating. Such wrinkles (spoking) are considered to be formed due to over-time change in the shape of rolled film.

The shape of film is thought to change over time due to residual stress in the film, and thus to suppress this, annealing may be performed in order to reduce residual stress in fluororesin film, or conditions of production may be adjusted, including conditions of melt extrusion, such as the degree of lip opening of the T-die and air gap, and conditions of winding of film, so that little residual stress remains in the production step of the film.

Furthermore, it is usually difficult to make fluororesin adhesive to copper foil. For this reason, it is preferable to perform surface treatment for fluororesin film to improve lamination properties. For such surface treatment, mainly, a method in which the amount of oxygen atoms on the surface of resin is increased is generally known.

It has been found that the effect of surface treatment of fluororesin film to improve such adhesiveness tends to be reduced by heating. This is assumed to be because oxygen atoms on the surface are eliminated by heating and thus the amount of oxygen atoms on the surface is reduced. In the step of lamination, sometimes film is pre-heated, for example, at a temperature higher than the glass transition temperature and less than the melting point of the film, and then laminated to improve productivity. It has been found that, for the fluorine film which has been exposed to heat to have sufficient adhesiveness when bonded to copper foil, it is necessary that the film has an oxygen element percentage of 1.35 atom% or more as measured when the film is heat treated at 180°C for 3 minutes and then the state of the surface to be bonded to copper foil is observed by scanning X-ray photoelectron spectroscopy (XPS/ESCA).

In view of the above, a fluororesin film in which defects in lamination are reduced and which is highly adhesive to copper foil can be obtained by satisfying the two requirements of:

(1) an absolute value of the rate of dimensional change in MD and TD before and after heat treatment of 2.0% or less as measured when the film is heat treated at 180°C for 10 minutes and then cooled to 25°C; and
(2) an oxygen element percentage of 1.35 atom% or more as measured when heat treatment is performed at 180°C for 3 minutes and then the state of the surface to be bonded to copper foil is observed by scanning X-ray photoelectron spectroscopy (XPS/ESCA).

To obtain a fluororesin film satisfying both properties of (1) and (2) above, conditions of treatment step after forming a fluororesin film are important.

As described above, an example of methods for reducing shrinkage rate to achieve the object of the present disclosure is an annealing treatment.

Usually annealing treatment for fluororesin means heat treatment. Thus, when annealing treatment is performed after surface treatment, the amount of oxygen atoms is reduced and consequently adhesiveness is reduced. Furthermore, adhesiveness is reduced in the pre-heating step in lamination, and thus when performing annealing treatment, it is necessary to select appropriate conditions of surface treatment and annealing treatment. To avoid the problem with annealing treatment, an approach may be taken, in which internal stress is reduced by adjusting the step for producing film and the like.

In the present disclosure, a fluororesin film satisfying (1) and (2) above is produced by adjusting the above conditions to reduce defects in lamination and achieve excellent adhesiveness.

The present disclosure will be described in more detail below.

The present disclosure relates to a fluororesin film. The resin constituting the fluororesin film is not limited and may be a polymer including a fluorine atom. Two or more of polymers including a fluorine atom may be used. Resin other than fluororesin, rubber, an additive and filler may also be included. Furthermore, the fluororesin may include at least one functional group selected from a carbonyl group-containing group (e.g., an acid anhydride group, a group having a carbonyl group between carbon atoms of a hydrocarbon group, a carbonate group, a carboxyl group, a haloformyl group, and an alkoxy carbonyl group), a hydroxyl group, an epoxy group, an amide group, an amino group and an isocyanate group.

The method for introducing the above functional group is not limited, and the functional group may be introduced into resin when producing fluororesin. In that case, the functional group is derived from at least one selected from the group consisting of a monomer, a chain transfer agent and a polymerization initiator used in production. Examples of monomers above include itaconic anhydride, citraconic anhydride, 5-norbornene-2,3-dicarboxylic anhydride and maleic anhydride. Examples of chain transfer agents include those derived from methanol, acetic acid, acetic anhydride, methyl acetate, ethylene glycol or propylene glycol. Examples of polymerization initiators include ammonium persulfate, potassium persulfate, di-n-propyl peroxydicarbonate, diisopropyl peroxycarbonate, tert-butyl peroxyisopropyl carbonate, bis(4-tert-butylcyclohexyl)peroxy dicarbonate and di-2-ethylhexyl peroxydicarbonate.

A fluororesin which can be melt molded is more preferred as fluororesin. Examples thereof include a tetrafluoroethylene·perfluoroalkyl vinyl ether copolymer (PFA), a copolymer including a chlorotrifluoroethylene (CTFE) unit (CTFE copolymer), a tetrafluoroethylene·hexafluoropropylene copolymer (FEP), a tetrafluoroethylene·ethylene copolymer (ETFE), polychlorotrifluoroethylene (PCTFE), a chlorotrifluoroethylene·ethylene copolymer (ECTFE), polyvinylidene fluoride (PVDF), polyvinyl fluoride (PVF), a tetrafluoroethylene·hexafluoropropylene·vinylidene fluoride copolymer (THV) and a tetrafluoroethylene·vinylidene fluoride copolymer.

Of these fluororesins which can be melt molded, a tetrafluoroethylene·perfluoroalkyl vinyl ether copolymer (PFA) and a tetrafluoroethylene·hexafluoropropylene copolymer (FEP) are preferred.

Use of the above fluororesin which can be melt molded allows melt molding, and thus the cost of processing can be lower than cases using PTFE. Furthermore, adhesiveness when bonding to copper foil can be improved.

It is preferable that the resin constituting the above fluororesin film has a glass transition temperature of 40°C or more. A glass transition temperature of 40°C or more is preferred because the resin is less likely to be deformed at the ambient temperature when roll film is stored at room temperature. The resin has a glass transition temperature of more preferably 60°C or more and further preferably 80°C or more. The upper limit is not limited, and is preferably 200°C or less, more preferably 160°C or less, and further preferably 120°C or less in view of adhesion.

The above PFA has a melting point of preferably 180 to 340°C, more preferably 230 to 330°C and further preferably 280 to 320°C. The above melting point corresponds to the local maximum value in a heat-of-fusion curve when temperature is increased at a rate of 10°C/ minute using a differential scanning calorimeter (DSC) .

The above PFA is not limited, and a copolymer in which the molar ratio between the TFE unit and the PAVE unit (TFE unit/ PAVE unit) is 70/30 or more and less than 99.5/0.5 is preferred. The molar ratio is more preferably 70/30 or more and 98.9/1.1 or less, and further preferably 80/20 or more and 98.5/1.5 or less. When the ratio of the TFE unit is very low, mechanical properties tend to be reduced. When the ratio of the TFE unit is very high, the resin has extremely high melting point and moldability tends to be reduced. The above PFA may be a copolymer consisting of only TFE and PAVE or is preferably a copolymer in which the ratio of the monomer unit derived from a monomer copolymerizable with TFE and PAVE is 0.1 to 10% by mole and the total of the TFE unit and the PAVE unit is 90 to 99.9% by mole. Examples of monomers copolymerizable with TFE and PAVE include HFP, a vinyl monomer represented by $CZ_3Z_4=CZ_3(CF_2)_nZ_6$ (in which $Z_3$, $Z_4$ and $Z_5$ are the same or different and represent a hydrogen atom or a fluorine atom, $Z_3$ represents a hydrogen atom, a fluorine atom or a chlorine atom, and n represents an integer of 2 to 10), and an alkyl perfluorovinyl ether derivative represented by $CF_2=CF-OCH_2-Rf_7$ (in which $Rf_7$ represents a perfluoroalkyl group having 1 to 5 carbon atoms). Examples of other copolymerizable monomers include a cyclic hydrocarbon monomer having an acid anhydride group. Examples of acid anhydride monomers include itaconic anhydride, citraconic anhydride, 5-norbornene-2,3-dicarboxylic anhydride and maleic anhydride. One of the acid anhydride monomers may be used alone or two or more of them may be used in combination.

The above PFA has a melt flow rate (MFR) of preferably 0.1 to 100 g/ 10 minutes, more preferably 0.5 to 90 g/ 10 minutes, and further preferably 1.0 to 85 g/ 10 minutes. In the present description, MFR is obtained by measurement in accordance with ASTM D3307 under conditions of a temperature of 372°C and a load of 5.0 kg.

The above FEP is not limited and a copolymer in which the molar ratio between the TFE unit and the HEP unit (TFE unit/ HEP unit) is 70/30 or more and less than 99/1 is preferred. The molar ratio is more preferably 70/30 or more and 98.9/1.1 or less, and further preferably 80/20 or more and 97/3 or less. When the ratio of the TFE unit is very low, mechanical properties tend to be reduced. When the ratio of the TFE unit is very high, the resin has extremely high melting point and moldability tends to be reduced. FEP is also preferably a copolymer in which the ratio of the monomer unit derived from a monomer copolymerizable with TFE and HFP is 0.1 to 10% by mole and the total of the TFE unit and the HFP unit is 90 to 99.9% by mole. Examples of monomers copolymerizable with TFE and HFP include an alkyl perfluorovinyl ether derivative. Examples of other copolymerizable monomers include a cyclic hydrocarbon monomer having an acid anhydride group. Examples of acid anhydride monomers include itaconic anhydride, citraconic anhydride, 5-norbornene-2,3-dicarboxylic anhydride and maleic anhydride. One of the acid anhydride monomers may be used alone or two or more of them may be used in combination.

The above FEP has a melting point of preferably 150 to 320°C, more preferably 200 to 300°C and further preferably 240 to 280°C. The above melting point corresponds to the local maximum value in a heat-of-fusion curve when temperature is increased at a rate of 10°C/ minute using a differential scanning calorimeter (DSC).

The above FEP has MFR of preferably 0.01 to 100 g/ 10 minutes, more preferably 0.1 to 80 g/ 10 minutes, further preferably 1 to 60 g/ 10 minutes, and particularly preferably 1 to 50 g/ 10 minutes.

It is preferable that the number of functional groups in the above fluororesin is small, in particular, the number of unstable terminal groups is small. Such fluororesin may be produced by a method in which conditions in production (in polymerization reaction) are adjusted. The number of unstable terminal groups is reduced by fluorine gas treatment, heat treatment, supercritical gas extraction and the like for fluorine resin after polymerization. Fluorine gas treatment is preferred because it is excellent in processing efficiency and part or all of the unstable terminal groups are converted into -CF$_3$ to form a stable terminal group. It is preferable to use fluorine resin in which the number of unstable terminal groups is reduced because dielectric loss tangent is reduced and loss of electric signals is reduced.

The number of the above unstable terminal groups is not limited, and is preferably 450 or less, more preferably 250 or less, further preferably 100 or less, and most preferably 50 or less per 10$^6$ carbon atoms in the main chain of the fluororesin. The number is preferably less than 10 and more preferably 5 or less in consideration of the effect of reduction of dielectric loss tangent.

Specific examples of unstable terminal groups include functional groups such as -COF, -COOH free, -COOH bonded, a hydroxyl group (e.g., -CH$_2$OH), -CONH$_2$, -COOR (e.g., R=CH$_3$), -CF$_2$H and -OCOO-R (e.g., n-propyl carbonate).

The number of unstable terminal groups is measured by the following method. First, the above fluororesin is melted and compression-molded to prepare a film having a thickness of 0.25 to 0.3 mm. The film is analyzed by Fourier transform infrared spectrophotometry to obtain an infrared absorption spectrum of the fluororesin, and a differential spectrum relative to a base spectrum of resin which is completely fluorinated and has no functional group is obtained. The number of unstable terminal groups per $1 \times 10^6$ carbon atoms in the fluororesin is calculated from the peak of absorption of a specific functional group appearing in the differential spectrum based on the following formula (A).

$$N = I \times K/t \qquad (A)$$

I: Absorbance
K: Coefficient of compensation
t: Thickness of film (mm)

The absorption frequency, molar extinction coefficient and coefficient of compensation for the unstable terminal group in the present description will be described in Table 1 for reference. The molar extinction coefficient is determined from the FT-IR data of a model low molecular weight compound.

[Table 1]

| Unstable terminal group | Absorption frequency (cm-1) | Molar extinction coefficient (1/cm/mol) | Coefficient of compensation | Model compound |
|---|---|---|---|---|
| -COF | 1883 | 600 | 388 | C$_7$F$_{15}$COF |
| -COOH (free) | 1815 | 530 | 439 | H(CF$_2$)$_6$COOH |

(continued)

| Unstable terminal group | Absorption frequency (cm-1) | Molar extinction coefficient (1/cm/mol) | Coefficient of compensation | Model compound |
|---|---|---|---|---|
| -COOH (bonded) | 1779 | 530 | 439 | $H(CF_2)_6COOH$ |
| -COOCH3 | 1795 | 680 | 342 | $C_7F_{15}COOCH_3$ |
| -CONH2 | 3436 | 506 | 460 | $C_7F_{15}CONH_2$ |
| -CH2OH | 3648 | 104 | 2236 | $C_7F_{15}CH_2OH$ |
| -CF2H | 3020 | 8.8 | 26485 | $H(CF_2CF_2)_3CH_2OH$ |
| -OC(=O)O-R | 1817 | - | 1426 | - |

The above fluorination may be performed by bringing fluororesin which has not been fluorinated into contact with a fluorine-containing compound.

Examples of fluorine-containing compounds described above include, but are not limited to, a source of fluorine radicals, which generates a fluorine radical under conditions of fluorination. Examples of sources of fluorine radicals include $F_2$ gas, $CoF_3$, $AgF_2$, $UF_6$, $OF_2$, $N_2F_2$, $CF_3OF$ and fluorinated halogen (e.g., $IF_5$, $ClF_3$).

While the concentration of the above source of fluorine radicals such as $F_2$ gas may be 100%, the source is used after being mixed with inert gas and diluted to preferably 5 to 50% by mass, more preferably 15 to 30% by mass from the point of view of safety. Examples of inert gas described above include nitrogen gas, helium gas and argon gas, and nitrogen gas is preferred from the economic point of view.

The condition of fluorination is not limited. Molten fluorine resin may be brought into contact with a fluorine-containing compound at usually the melting point of the fluorine resin or lower, preferably a temperature of 20 to 220°C and more preferably 100 to 200°C. The time of fluorination is usually 1 to 30 hours, and preferably 5 to 25 hours. For the above fluorination, it is preferable that fluorine resin which has not been fluorinated is brought into contact with fluorine gas ($F_2$ gas) .

In the present description, the content of the respective monomer units constituting fluorine resin may be calculated by appropriately combining NMR, FT-IR, elemental analysis and fluorescent X-ray analysis depending on the type of monomers.

The fluororesin film according to the present disclosure may include a component other than fluororesin. Examples of components the film may include include, but are not limited to, a filler such as silica particles and glass staple fiber and thermosetting resin and thermoplastic resin which do not contain fluorine.

The fluororesin-containing composition according to the present disclosure may include spherical silica particles. Spherical silica particles improve flowability of resin, and molding is easy even when a large amount of silica is mixed.

The above spherical silica particles mean those which are substantially a sphere, and have a sphericity of preferably 0.80 or more, more preferably 0.85 or more, further preferably 0.90 or more, and most preferably 0.95 or more. Sphericity is calculated from the area and the circumference of a particle observed in a micrograph taken by SEM based on (sphericity) = {$4\pi \times$ (area) $\div$ (circumference)2}. A sphericity close to 1 means that the particle is close to a sphere. More specifically, an average value of 100 particles measured using an image processing device (FPIA-3000 made by Spectris) is used.

The spherical silica particle preferably has a D90/D10 of 2 or more (preferably 2.3 or more, 2.5 or more) and D50 of 10 $\mu$m or less when volumes of particles with small particle size are integrated. The spherical silica particle has a D90/D50 of preferably 1.5 or more (more preferably 1.6 or more). The spherical silica particle has a D50/D10 of preferably 1.5 or more (more preferably 1.6 or more). Spherical silica particles with small particle size can enter into the gap between spherical silica particles with large particle size, and this provides excellent filling properties and improves flowability. In particular, it is preferable that in the particle size distribution, frequencies at the side of small particle size are high compared to the Gaussian curve. The particle size may be measured by a laser diffraction scattering particle size distribution meter. Furthermore, it is preferable that coarse particles with a predetermined particle size or more are removed by a filter and the like.

The above spherical silica particle has a water absorption of preferably 1.0% or less, and more preferably 0.5% or less. Water absorption is based on the mass of dried silica particles. For the measurement of water absorption, a dried sample is left at 40°C and 80% RH for 1 hour and the content of water generated when the sample is heated at 200°C is measured by a Karl Fischer moisture analyzer, and water absorption is calculated.

For the above spherical silica particles, the fluororesin composition is heated at 600°C for 30 minutes in air to burn the fluororesin and the spherical silica particles are collected, and then the above parameters may be measured using the above method.

The silica powder according to the present invention may be surface-treated. Previous surface treatment can suppress aggregation of silica particles and allows silica particles to be dispersed well in the resin composition.

The above surface treatment is not limited and any known surface treatment may be used. Specific examples include a treatment using a silane coupling agent such as epoxy silane, amino silane, vinyl silane and acrylic silane having a functional group, hydrophobic alkyl silane, phenyl silane and fluorinated alkyl silane, a plasma treatment and a fluorination treatment.

Examples of silane coupling agents described above include epoxy silane such as γ-glycidoxypropyl triethoxysilane and β-(3,4-epoxycyclohexyl)ethyltrimethoxysilane, amino silane such as aminopropyl triethoxysilane and N-phenylaminopropyl trimethoxysilane, vinyl silane such as vinyl trimethoxysilane and acrylic silane such as acryloxy trimethoxysilane.

For the above spherical silica, commercially available silica particles which satisfy the above features may also be used. Examples of commercially available silica particles include Denka Fused Silica FB Grade (made by Denka Company Limited), Denka Fused Silica SFP Grade (made by Denka Company Limited), EXCELICA (made by Tokuyama Corporation), high purity synthesized spherical silica ADMAFINE (made by Admatechs), ADMANANO (made by Admatechs) and ADMAFUSE (made by Admatechs).

In the film according to the present disclosure, an oxygen element percentage as measured when heat treatment is performed at 180°C for 3 minutes and then the state of one or both surfaces of the film is observed by ESCA is 1.35 atom% or more. The above-described oxygen element percentage is preferably 1.5 atom% or more, more preferably 1.8 atom% or more, and most preferably 2.0 atom% or more.

The film according to the present disclosure may be a fluorine film in which a difference between the oxygen element percentage when the state of surface of the film is observed by scanning X-ray photoelectron spectroscopy (XPS/ESCA) and the oxygen element percentage measured by scanning X-ray photoelectron spectroscopy (XPS/ESCA) after etching the film by argon gas cluster ion beams at an incident angle of 45° in the direction of the depth for 15 minutes is 1.0 atom% or more. By increasing the oxygen element percentage only on the surface which contributes to adhesion, sufficient adhesion strength can be achieved without reducing dielectric properties.

The heat treatment at 180°C for 3 minutes means that the film is put on a metal tray and heat-treated in an electric oven in air atmosphere.

The fluororesin film according to the present disclosure has an absolute value of the rate of dimensional change in MD and TD before and after heat treatment of 2.0% or less as measured when the film is heat-treated at 180°C for 10 minutes and then cooled to 25°C.

The fluororesin film has a rate of dimensional change of more preferably 1.8% or less, and most preferably 1.5% or less.

In the present disclosure, for the rate of dimensional change, marks are put at intervals of 180 mm on a film sample which has been cut into a 300 mm square, the sample is heat treated for 10 minutes in air atmosphere in an electric oven set at 180°C without load and cooled to 25°C, and the distance between the marks on the film is measured in the MD direction and the TD direction respectively and the rate of dimensional change is calculated from the amount of change in the distance between the marks before and after the heat treatment.

It is preferable that the fluororesin film of the present disclosure has a dielectric loss tangent at 10 GHz of less than 0.0015. The dielectric loss tangent in that range is preferred because loss of electric signals in the circuit can be kept low. The fluororesin film has a dielectric loss tangent of more preferably less than 0.0013, further preferably less than 0.0010, and most preferably 0.00050 or less.

Supposing transmission of signals and transmission and reception with antennas at high frequency, the fluororesin has a dielectric loss tangent at 40 GHz of preferably less than 0.0015, more preferably less than 0.0013, further preferably less than 0.0010, and most preferably 0.00050 or less.

To set the dielectric loss tangent to the above range, it is preferable to use resin in which the number of unstable terminal groups is small. It is more preferable to use a fluororesin which has been fluorinated at the terminal.

The above fluororesin film has an adhesion strength of preferably 0.8 N/mm or more, more preferably 0.9 N/mm or more, and further preferably 1.0 N/mm or more when bonded to copper foil having a surface roughness Rz of 1.5 μm or less under conditions of a temperature of the melting point or more and the melting point +30°C or less, a pressure of 1.5 to 3.0 MPa and a time of 300 to 600 seconds using a vacuum heat press. The adhesion strength as used herein means adhesion strength of a laminate prepared by bonding under the above conditions, which is measured under the conditions described in Examples.

It is preferable that the one or both surfaces of the above fluororesin film have an adhesion strength of more than 30 N/m when the surfaces of the film are mutually bonded at 200°C. A fluororesin with such adhesion strength has excellent adhesiveness when used in combination with other substrates even after heat treating the fluororesin film. The fluororesin film has an adhesive strength of preferably more than 50 N/m and more preferably more than 100 N/m.

(Method for producing fluororesin film)

In the following, the method for producing the fluororesin film of the present disclosure explained above will be described in detail. The fluororesin film of the present disclosure is not limited to those produced by the following production method.

For the fluororesin film of the present disclosure, the method of forming film is not limited. Examples thereof include a melt molding method such as extrusion and a casting method in which a solution or a dispersion containing fluororesin is prepared and then applied to and dried on a substrate. Furthermore, the film may be uniaxially or biaxially stretched, or may be an unstretched film.

One or both surfaces of the fluororesin film obtained by such a method are surface-treated and annealed under appropriate conditions to give a fluororesin film satisfying the above requirements (1) and (2).

The method of surface modification is not limited, and the surface may be modified by any known method.

For surface modification of fluororesin film, a traditional discharge treatment such as a corona discharge treatment, a glow discharge treatment, a plasma discharge treatment and a sputtering treatment may be used. For example, surface free energy may be controlled by introducing, for example, oxygen gas, nitrogen gas or hydrogen gas into discharge atmosphere. Alternatively, the surface to be modified is exposed to atmosphere of an organic compound-containing inert gas, and high frequency voltage is applied between electrodes to generate discharge and form active species on the surface. Then the functional group of the organic compound is introduced thereinto or a polymerizable organic compound is graft-polymerized to allow the surface modification. Examples of inert gases described above include nitrogen gas, helium gas and argon gas.

Examples of organic compounds in the organic compound-containing inert gas include polymerizable or non-polymerizable oxygen atom-containing organic compounds such as vinyl esters such as vinyl acetate and vinyl formate; acrylates such as glycidyl methacrylate; ethers such as vinyl ethyl ether, vinyl methyl ether and glycidyl methyl ether; carboxylic acids such as acetic acid and formic acid; alcohols such as methyl alcohol, ethyl alcohol, phenol and ethylene glycol; ketones such as acetone and methyl ethyl ketone; carboxylates such as ethyl acetate and ethyl formate; and acrylic acids such as acrylic acid and methacrylic acid. Of them, vinyl esters, acrylates and ketones are preferred, and in particular vinyl acetate and glycidyl methacrylate are preferred because the modified surface is less likely to be deactivated, i.e., has long life and can be easily handled in terms of safety.

The concentration of the organic compound in the above organic compound-containing inert gas varies depending on its type and the type of fluororesins of which surface is to be modified. The concentration is usually 0.1 to 3.0% by volume, preferably 0.1 to 1.0% by volume, more preferably 0.15 to 1.0% by volume, and further preferably 0.30 to 1.0% by volume. Conditions of discharge may be appropriately selected depending on the intended degree of surface modification, the type of fluororesins and the type and the concentration of organic compounds. Usually the discharge treatment is performed in the amount of discharge of 50 to 1500 W · minute/ $m^2$, and preferably 70 W · minute/ $m^2$ or more and 1400 W · minute/ $m^2$ or less. The discharge treatment may be performed at any temperature of 0°C or more to 100°C or less. The temperature is preferably 80°C or less in consideration of elongation and wrinkles of film. For the degree of surface modification, an abundance of oxygen element in observation by ESCA is 2.6% or more, preferably 2.8% or more, more preferably 3.0% or more, and further preferably 3.5% or more in consideration of reduction of adhesiveness on the surface due to heat in post-processing. The upper limit is not limited, but is preferably 25.0% or less in consideration of productivity and impacts on other physical properties. The abundance of nitrogen element is not limited, but is preferably 0.1% or more. The fluororesin film has a thickness of preferably 2.5 to 1000 $\mu$m, more preferably 5 to 500 $\mu$m and further preferably 12.5 to 150 $\mu$m per film.

It is preferable that in the production of the fluororesin film of the present disclosure, annealing treatment is performed after the above surface treatment. Furthermore, heat treatment may be performed in the process of lamination of the film and other materials such as copper foil. These heat treatments cause a reduction in the amount of oxygen on the surface of the fluororesin film. Thus, it is preferable to modify the surface under conditions that provide a sufficient amount of oxygen on the surface when the fluororesin film and other materials such as copper foil are actually stacked.

(Annealing treatment)

Annealing treatment may be performed by heat treatment. In this heat treatment, for example, film may be passed through a heating furnace by a roll-to-roll method.

The temperature of annealing treatment is preferably the glass transition temperature -20°C or more and less than the melting point, more preferably the glass transition temperature or more and the melting point - 20°C or less, and further preferably the glass transition temperature or more and the melting point -60°C or less. The time of annealing treatment is not limited, and may be appropriately adjusted to, for example, 0.5 to 60 minutes. When the film which has been passed through the annealing furnace and remains at high temperature comes into contact with the roll of the winding apparatus, the film is likely to be deformed (waved) due to heat shrinkage caused by the temperature change.

To avoid this, the film may be cooled by passing it through a cooling zone after the high temperature annealing zone and then taken up on the winding apparatus. The method of cooling is not limited, and the film may be cooled by cool air or a cooling roll. It is preferable that the temperature of the film is brought to less than the glass transition temperature.

When the film is heated by the above roll-to-roll method, the tension may be appropriately set depending on the thickness of the film and the set temperature, and is preferably 20 N/m or less. Heating under these conditions is preferable because internal stress can be sufficiently released and dimensional change and the like does not occur.

The order of the above surface treatment and annealing treatment is not limited. The number of times of the respective steps to be executed is not limited to once, either, and may be executed twice or more. Since tension is applied to the film in the step of surface treatment, it is preferable to perform the surface treatment first and then perform the annealing treatment so as to control the thermal shrinkage rate. Furthermore, a slit with a predetermined width and length may be formed before or after these treatments. It is preferable that in those cases the tension is adjusted so that the film is not elongated.

The fluororesin film of the present disclosure may be stacked to other substrates and used as a sheet for a printed wiring board. The fluororesin film of the present disclosure has a thickness of preferably 2.5 to 1000 $\mu$m, more preferably 5 to 500 $\mu$m, and further preferably 12.5 to 150 $\mu$m. The thickness may be selected in consideration of the balance between electric properties and linear expansion coefficient of the laminate and the like.

The present disclosure also includes a laminate in which copper foil is bonded to one or both surfaces of the above fluororesin film. As described above, the film comprising the fluororesin according to the present disclosure has excellent adhesiveness. It is preferable that the above copper foil has Rz of 1.5 $\mu$m or less. In other words, the fluororesin composition according to the present invention has excellent adhesion even to highly smooth copper foil having Rz of 1.5 $\mu$m or less. The copper foil may have Rz of 1.5 $\mu$m or less on at least the surface to be bonded to the above fluororesin film, and the value of Rz on the other surface is not limited.

The thickness of the copper foil is not limited, and the copper foil has a thickness of preferably 1 to 100 $\mu$m, more preferably 5 to 50 $\mu$m, and further preferably 9 to 35 $\mu$m.

The above copper foil is not limited and specific examples thereof include rolled copper foil and electrolytic copper foil.

Copper foil having Rz of 1.5 $\mu$m or less is not limited and commercially available copper foil may be used. Examples of commercially available copper foil having Rz of 1.5 $\mu$m or less include electrolytic copper foil CF-T9DA-SV-18 (thickness 18 $\mu$m, Rz 0.85 $\mu$m) (made by Fukuda Metal Foil & Powder Co., Ltd.).

The above copper foil may be surface-treated to improve adhesion strength to the fluororesin film of the present disclosure.

The surface treatment includes, but is not limited to, a silane coupling treatment, a plasma treatment, a corona treatment, a UV treatment and an electron beam treatment. The reactive functional group of the silane coupling agent is not limited, and the silane coupling agent may preferably include at least one group selected from an amino group, a (meth)acrylic group, a mercapto group and an epoxy group at the terminal in view of adhesion to the resin substrate. Examples of hydrolytic groups include, but are not limited to, an alkoxy group such as a methoxy group and an ethoxy group. An antirust layer (an oxide coating such as chromate) and a heat resistant layer may be formed on the copper foil used in the present disclosure.

Surface-treated copper foil having a surface-treated layer of the above silane compound on the surface may be produced by preparing a solution containing a silane compound and surface treating the copper foil using the solution.

The copper foil may have a roughened layer on the surface in order to increase adhesion to the resin substrate and the like.

If roughening treatment is likely to degrade properties required in the present disclosure, the amount of roughening particles to be electrodeposited on the copper foil surface may be reduced if necessary, or roughening treatment may not be performed.

One or more layers selected from the group consisting of a heat-resisting treated layer, an antirust layer and a chromate-treated layer may be formed between the copper foil and the surface-treated layer in order to improve various properties. Those layers may be a single layer or multiple layers.

It is preferable that the above laminate has an adhesion strength between the copper foil and the fluororesin film of 0.8 N/mm or more. Using the method described above allows the laminate to have such adhesion strength. By setting the adhesion strength to 0.9 N/mm or more, or 1.0 N/mm or more, the laminate may be suitably used as a copper-clad laminated board or a substrate for circuits. The adhesion strength as used herein means the adhesion strength measured under conditions described in Examples. In the case of a laminate prepared by bonding copper foil to the surface-treated side of a fluororesin film having only one side surface-treated, the non-treated side of the fluororesin film may also be surface-modified in order to improve adhesiveness of the laminate to other materials.

The present disclosure also includes a laminate comprising a copper foil layer, the above fluororesin film and a substrate layer. The substrate layer is not limited. It is preferable that the laminate has a fabric layer made of glass fiber and a resin film layer.

The above fabric layer made of glass fiber is made of, for example, glass cloth or glass non-woven fabric.

Commercially available glass cloth may be used, and glass cloth which has been treated with a silane coupling agent is preferred in order to improve affinity with fluororesin. Materials of glass cloth include E-glass, C-glass, A-glass, S-glass, D-glass, NE-glass and low dielectric glass. E-glass, S-glass and NE-glass are preferred because they are readily available. The type of weaving fiber may be plain weave or twill weave. The glass cloth has a thickness of usually 5 to 90 $\mu$m and preferably 10 to 75 $\mu$m. It is preferable to use the glass cloth thinner than the fluororesin film used.

For the above laminate, glass non-woven fabric may be used as the fabric layer made of glass fiber. Glass non-woven fabric refers to a fabric prepared by bonding glass staple fiber with a small amount of a binder compound (resin or an inorganic substance), or fabric in which pieces of glass staple fiber are entangled to maintain the shape without using a binder compound. Commercially available ones may be used. The glass staple fiber has a diameter of preferably 0.5 to 30 $\mu$m, and a fiber length of preferably 5 to 30 mm. Examples of binder compounds include a resin such as epoxy resin, acrylic resin, cellulose, polyvinyl alcohol and fluororesin, and an inorganic compound such as a silica compound. The amount of the binder compound used is usually 3 to 15% by mass based on the glass staple fiber. Materials of glass staple fiber include E-glass, C-glass, A-glass, S-glass, D-glass, NE-glass and low dielectric glass. The glass nonwoven fabric has a thickness of usually 50 $\mu$m to 1000 $\mu$m, and preferably 100 to 900 $\mu$m. The thickness of the glass non-woven fabric in the present application refers to values measured according to JIS P8118: 1998 using Digital Gauge DG-925 (load 110 g, diameter 10 mm) made by Ono Sokki Co., Ltd. To improve affinity with fluororesin, the glass non-woven fabric may be treated with a silane coupling agent.

Since most glass nonwoven fabrics have a very high porosity of 80% or more, it is preferable to use a glass nonwoven fabric thicker than the sheet of fluororesin; and it is preferable to compress glass nonwoven fabric under pressure and then used.

The above fabric layer made of the glass fiber may be a layer in which glass cloth and glass non-woven fabric are stacked. This combines both features and provides suitable qualities.

The fabric layer made of the glass fiber may be in the form of prepreg which has been impregnated with resin.

In the above laminate, the fabric layer made of glass fiber may be bonded to the fluororesin film at the interface, or the fabric layer made of glass fiber may be partly or entirely impregnated with the fluororesin film.

Furthermore, prepreg may be prepared by impregnating fabric made of glass fiber with a fluororesin composition. The prepreg prepared as described above may be stacked with the fluororesin film of the present disclosure. In that case, the fluororesin composition used for preparing prepreg is not limited, and the fluororesin film of the present disclosure may be used.

Heat resistant resin film and thermosetting resin film are preferred as the resin film used as the above substrate. Examples of heat resistant resin film include polyimide, liquid crystal polymer, polyphenylene sulfide, cycloolefin polymer and polystyrene. Examples of thermosetting resins include those including epoxy resin, bismaleimide, polyphenylene oxide, polyphenylene ether and polybutadiene.

The heat resistant resin film and the thermosetting resin film may also include reinforcing fiber. Examples of reinforcing fibers include, but are not limited to, glass cloth, in particular preferably low dielectric glass cloth.

Properties of the heat resistant resin film and the thermosetting resin film, such as dielectric properties, linear expansion coefficient and water absorption ratio are not limited. For example, the dielectric constant at 20 GHz is preferably 3.8 or less, more preferably 3.4 or less and further preferably 3.0 or less. The dielectric loss tangent at 20 GHz is preferably 0.0030 or less, more preferably 0.0025 or less, and further preferably 0.0020 or less. The linear expansion coefficient is preferably 100 ppm/°C or less, more preferably 70 ppm/°C or less, further preferably 40 ppm/°C or less, and most preferably 20 ppm/°C or less. The water absorption is preferably 1.0% or less, more preferably 0.5% or less, and further preferably 0.1% or less.

The fluororesin film of the present disclosure may be used for a laminate comprising copper foil, a substrate layer and the fluororesin film described above.

The method for forming a composite of the copper foil, a substrate layer and the fluororesin film is not limited, and includes the following two.

(i) A method in which copper foil, a substrate layer and a fluororesin film which has been previously molded are stacked by applying pressure using a roll-to-roll process or a pressing machine while heating.
(ii) A method in which fluororesin film is bonded to one side of copper foil to produce a laminate and the laminate is stacked on a substrate layer by applying pressure while heating.

In the above method (ii), the laminate composed of copper foil, the substrate layer and the fluororesin film may be surface-treated and then bonded to other layers. Furthermore, the surface of the fluororesin film to be bonded to the substrate layer may be surface-treated.

In these methods, when a copper-clad laminate which essentially comprises the fluororesin film and copper foil is stacked on a substrate layer such as a fabric layer made of glass fiber or resin film layer, the side of the fluororesin film layer of the copper-clad laminate may be stacked by bonding to the substrate layer. In that case, the side of the fluororesin film layer of the copper-clad laminate may be surface-treated before lamination to improve adhesion properties. The surface treatment at that stage is not limited, and examples thereof include plasma treatment described above.

For the above laminate, the order of lamination of the copper foil layer, the substrate layer and the fluororesin film described above, and the method for producing them are not limited. The layer structure may be determined depending on the purposes of use.

Specifically, the order of lamination may be substrate layer/ fluororesin film/ copper foil layer, copper foil layer/ fluororesin film/ substrate layer/ fluororesin film/ copper foil layer, and copper foil layer/ substrate layer/ fluororesin film/ substrate layer/ copper foil layer.

Furthermore, the laminate may have other layers where necessary.

The copper foil for the above laminate may be the same as the copper foil for the laminate with the fluororesin film described in detail above.

To obtain the above structure of the laminate, the fluororesin film of the present disclosure is used with copper foil bonded to one or both sides. As described above, the fluororesin film of the present disclosure has excellent adhesiveness. Thus the fluororesin film has excellent adhesiveness even to highly smooth copper foil having Rz of 1.5 $\mu$m or less. It is preferable that the laminate has an adhesion strength between the copper foil and the fluororesin film of preferably 0.8 N/mm or more. By setting the adhesion strength to 0.9 N/mm or more, more preferably 1.0 N/mm or more, the laminate can be suitably used as a copper-clad laminated board and a substrate for circuits. The adhesion strength as used herein means the adhesion strength measured under conditions described in Examples.

Certain irregularities have been formed on the surface of copper foil to be used for a substrate for circuits in order to provide adhesion to an insulation layer. However, irregularities are not preferred because those irregularities on the surface of copper foil cause loss of electric signals in high frequency applications. The above laminate has suitable adhesiveness even to highly smooth copper foil and thus can be suitably used as a substrate for circuits.

The fluororesin film of the present disclosure has the advantage that no defects occur in lamination and the film is highly adhesive to copper foil. Since the fluororesin film is adhesive even to highly smooth copper foil having Rz of 1.5 $\mu$m or less, a laminate which can be suitably used as a copper-clad laminate and a substrate for circuits, and for flat cable and coverlay can be obtained.

In the present disclosure, high frequency circuits include not only circuits transmitting only high frequency signals but also circuits including, on the same plane, channels which transmit non-high frequency signals, such as a channel which converts high frequency signals into low frequency signals and output the resulting low frequency signals to the outside and a channel for supplying a power source for driving a component corresponding to high frequency. Furthermore, the laminate may also be used as a circuit board for antennas and filters.

Examples

The present disclosure will be described in more detail with reference to Examples. The present invention is not limited to the following Examples.

(Composition of polymer)

The composition of polymer was measured by 19F-NMR.

(Melting point)

The melting point was calculated from the melting peak measured using a DSC apparatus while increasing the temperature at a temperature increase rate of 10°C/ minute.

(Glass transition temperature)

The glass transition temperature was calculated from the tan $\delta$ peak measured using a solid dynamic mechanical analyzer (DMA) at a frequency of 10 Hz and a strain of 0.1% while increasing the temperature at a temperature increase rate of 5°C/ minute.

(Melt flow rate: MFR)

The melt flow rate was measured in accordance with ASTM D3307 under conditions of a temperature of 372°C and a load of 5.0 kg.

(Thickness of fluororesin film)

The thickness of the fluororesin film was measured by a micrometer.

(Number of unstable terminal groups)

For the number of unstable terminal groups, the film was analyzed by using FT-IR Spectrometer 1760X (made by Perkin-Elmer).

(ESCA analysis of surface of fluororesin film)

The surface of the fluororesin film was observed using scanning X-ray photoelectron spectroscopy (XPS/ESCA) PHI 5000 Versa Probe II (made by ULVAC-PHI).

(Rate of dimensional change)

Marks were put on a film sample which had been cut into a 300 mm square at intervals of 180 mm in the MD direction and the TD direction, respectively. The sample was put on a metal plate covered with glass cloth impregnated with PTFE and heat-treated in air atmosphere in an electric oven set at 180°C for 10 minutes without load. Then the sample was cooled to 25°C (left to stand for 30 minutes or more in a room at 25°C), and the distance between the marks was measured by a caliper in the MD direction and the TD direction, respectively (in terms of mm, the caliper can measure up to two decimal places). The rate of dimensional change was calculated from the change in the distance between the marks before and after the heat treatment based on the following equation.

```
Thermal shrinkage rate = {(length after heat
treatment - length before heat treatment) / length before
heat treatment} × 100 (%)
```

(Wrinkles after annealing)

The presence of wrinkles was visually observed.

    o: Film not deformed (waved)
    ×: Film deformed (waved)

(Wrinkles in roll film)

The appearance after being taken up in the form of roll and stored at room temperature for 1 month was visually observed.

    o: Wrinkles due to spoking not formed or increased
    ×: Wrinkles due to spoking formed and increased

(Surface roughness of copper foil)

The catalog value of electrolytic copper foil CF-T9DA-SV-18 (thickness 18 μm/ Rz 0.85 μm) (made by Fukuda Metal Foil & Powder Co., Ltd.) was used.

(Adhesion strength between copper foil and fluororesin film)

A fluororesin film which had not been preheated or which had been preheated at the glass transition temperature or more and less than the melting point was stacked on copper foil in the order of copper foil/ fluororesin film/ copper foil to prepare a laminate by using a vacuum heat press. An aluminum plate was attached to one side of the laminate with adhesive tape, and peel strength was measured by sandwiching and pulling copper foil at a width of 10 mm in the direction at 90° relative to the plane of the laminate at a rate of 50 mm per minute using Tensilon Universal Testing Machine (made by Shimadzu Corporation). The resulting value was defined as adhesion strength.

(Adhesion strength between fluororesin films)

A sample prepared by stacking the surface-treated surfaces of fluororesin films by a heat press (200°C, 0.1 MPa, 60 seconds) was cut into a 10-mm wide strip. Using Tensilon Universal Testing Machine (made by Shimadzu Corporation), the strip was pulled at a rate of 100 mm per minute while being held at the portion which had not been bonded with the upper and lower chucks of Tensilon to measure peel strength. The resulting value was defined as adhesion strength.

(Dielectric constant and dielectric loss tangent of fluororesin film)

The dielectric constant and the dielectric loss tangent of the fluororesin film were measured by Split Cylinder Resonator CR-710 and CR-740 (made by EM Labs Inc.) at 10 GHz, 20 GHz and 40 GHz (26°C) and analyzed by Vector Network Analyzer P5007A (made by Keysight Technologies).

(Sample 1)

Fluororesin, PFA (TFE/ PPVE copolymer, composition: TFE/ PPVE = 95.8/ 4.2 (% by mass), MFR: 15.8 g/ 10 minutes, melting point: 305°C, number of unstable terminal groups: 297 per $10^6$ carbon atoms in the main chain) was melt extruded by a T die method and was taken up. Both surfaces of the resulting long roll film with a thickness of 50 $\mu$m was surface-treated (both surfaces of the film were subjected to corona discharge treatment by passing the film continuously along a roll-shaped ground electrode with allowing nitrogen gas containing 0.50% by volume of vinyl acetate to flow near the discharge electrode and the roll-shaped ground electrode in a corona discharge device at an amount of discharge of 1,324 W · minute/ $m^2$). The surface-treated long film was taken up in the form of a roll. The surface-treated film has a surface oxygen element percentage of 20.42% by ESCA surface analysis. The film has a glass transition temperature of 92°C.

(Sample 2)

A sample, which is a 50-$\mu$m thick film surface-treated on both sides, was prepared in the same manner as for Sample 1 except for setting the amount of discharge to 265 W · minute/ $m^2$. The sample has an oxygen element percentage of 11.64% by ESCA surface analysis.

(Sample 3)

A sample, which was a 50-$\mu$m thick film surface-treated on both sides, was prepared in the same manner as for Sample 1 except for setting the amount of discharge to 132 w · minute/ $m^2$. The film has an oxygen element percentage of 5.35% by ESCA surface analysis.

(Sample 4)

A sample, which was a 50-$\mu$m thick film surface-treated on both sides, was prepared in the same manner as for Sample 1 except for setting the amount of discharge to 88 W · minute/ $m^2$. The film has an oxygen element percentage of 3.66% by ESCA surface analysis.

(Sample 5)

A sample, which was a 50-$\mu$m thick film surface-treated on both sides, was prepared in the same manner as for Sample 1 except for setting the amount of discharge to 66 w · minute/ $m^2$. The sample has an oxygen element percentage of 2.54% by ESCA surface analysis.

(Sample 6)

A sample, which was a 50-$\mu$m thick film surface-treated on both sides, was prepared in the same manner as for Sample 2 except for changing the type of fluororesin to fluorinated PFA (TFE/ PPVE copolymer, composition: TFE/ PPVE = 95.8/ 4.2 (% by mass), MFR: 16.2 g/ 10 minutes, melting point: 305°C, number of unstable terminal groups: cannot be detected (less than 1 per 106 carbon atoms in the main chain)). The sample has an oxygen element percentage of 9.72 % by ESCA surface analysis. The film has a glass transition temperature of 94°C.

The condition of the surface treatment and the results of surface analysis of Samples 1 to 6 are shown in Table 2.

[Table 2]

| | Type of resin | Amount of discharge | Ratio of element on surface by ESCA measurement (%) | | | |
|---|---|---|---|---|---|---|
| | | W · min/m2 | F | C | O | N |
| Sample 1 | PFA | 1324 | 3.67 | 71.59 | 20.42 | 4.32 |
| Sample 2 | PFA | 265 | 33.84 | 51.60 | 11.64 | 2.91 |
| Sample 3 | PFA | 132 | 50.35 | 43.35 | 5.35 | 0.94 |
| Sample 4 | PFA | 88 | 55.60 | 40.02 | 3.66 | 0.72 |
| Sample 5 | PFA | 66 | 59.19 | 37.79 | 2.54 | 0.48 |
| Sample 6 | Fluorinated PFA | 265 | 31.81 | 55.98 | 9.72 | 2.49 |

(Example 1)

The film of Sample 1 was passed through an annealing furnace (in air atmosphere) at 180°C by a roll-to-roll method and was cooled in the cooling zone, and the long film was taken up in the form of a roll. At that stage, whether the film after annealing was deformed (waved) or not was visually observed. Next, a cut film sampled from the long roll film was put in an electric furnace at 180°C and heat-treated for 10 minutes, and then was cooled to room temperature. The rate of dimensional change was measured in the MD and TD directions and their absolute values were determined. The film taken on the roll was stored at room temperature for 1 month and spoking was evaluated.

(Example 2)

Annealing treatment was performed and subsequently the deformation (waving) of the film was evaluated, the rate of dimensional change was measured and spoking was evaluated in the same manner as in Example 1 except for using the film of Sample 2.

(Example 3)

Annealing treatment was performed and subsequently the deformation (waving) of the film was evaluated, the rate of dimensional change was measured and spoking was evaluated in the same manner as in Example 2 except for setting the temperature of the annealing furnace to 200°C.

(Example 4)

Annealing treatment was performed and subsequently the deformation (waving) of the film was evaluated, the rate of dimensional change was measured and spoking was evaluated in the same manner as in Example 1 except for using the film of Sample 3.

(Example 5)

Annealing treatment was performed and subsequently the deformation (waving) of the film was evaluated, the rate of dimensional change was measured and spoking was evaluated in the same manner as in Example 1 except for using the film of Sample 4.

(Example 6)

Annealing treatment was performed and subsequently the deformation (waving) of the film was evaluated, the rate of dimensional change was measured and spoking was evaluated in the same manner as in Example 1 except for using the film of Sample 5.

(Example 7)

Annealing treatment was performed and subsequently the deformation (waving) of the film was evaluated, the rate of dimensional change was measured and spoking was evaluated in the same manner as in Example 1 except for using the film of Sample 6.

(Example 8)

Annealing treatment was performed and subsequently the deformation (waving) of the film was evaluated, the rate of dimensional change was measured and spoking was evaluated in the same manner as in Example 1 except for not including the cooling zone in the annealing step.

(Comparative Example 1)

Annealing treatment was performed and subsequently the deformation (waving) of the film was evaluated, the rate of dimensional change was measured and spoking was evaluated in the same manner as in Example 2 except for setting the temperature of the annealing furnace to 250°C.

(Comparative Example 2)

The rate of dimensional change of Sample 2, which had not been annealed, was measured and spoking thereof was evaluated.
The results of Examples 1 to 8 and Comparative Examples 1 to 2 are shown in Table 3.

[Table 3]

| | | Example 1 | Example 2 | Example 3 | Example 4 | Example 5 | Example 6 | Example 7 | Example 8 | Comparative Example 1 | Comparative Example 2 |
|---|---|---|---|---|---|---|---|---|---|---|---|
| | | Sample 1 | Sample 2 | Sample 2 | Sample 3 | Sample 4 | Sample 5 | Sample 6 | Sample 1 | Sample 2 | Sample 2 |
| Annealing temperature (°C) | | 180 | 180 | 200 | 180 | 180 | 180 | 180 | 180 | 250 | - |
| Annealing Time (minute) | | 5 | 5 | 5 | 5 | 5 | 5 | 5 | 5 | 5 | - |
| Cooling zone | | Present | Present | Present | Present | Present | Present | Present | None | Present | - |
| Evaluation of deformation of film | | ○ | ○ | ○ | ○ | ○ | ○ | ○ | × | ○ | - |
| Rate of dimensional change (%) | MD | 0.83 | 0.91 | 7.45 | 078 | 1.01 | 0.92 | 0.88 | 0.71 | 2.05 | 224 |
| | TD | 0.36 | 0.58 | 0.64 | 0.37 | 0.51 | 0.42 | 0.5 | 0.3 | 0.43 | 1.01 |
| Evaluation of spoking | | ○ | ○ | ○ | ○ | ○ | ○ | ○ | - | × | × |

The results of Table 3 shows that spoking over time can be suppressed by adjusting conditions of the annealing treatment so as to set the absolute value of the ratio of the dimensional change after heat treatment at 180°C for 10 minutes to 2% or less. Furthermore, Example 8 shows that when the annealing step did not include the cooling zone, the roll film after annealing was deformed (waved) when the film was rolled out, and spoking could not be evaluated. Defects would be formed in such film in the step of bonding to copper foil and the like, and thus it is preferable to include the cooling step in the annealing step.

(Example 9)

The film annealed in Example 1 (Sample 1: 180) was cut into a 100 mm square and placed on a metal tray, and the tray was put in an electric oven at 180°C (air atmosphere) to perform heat treatment for 3 minutes. The surface of the film in contact with air during the heat treatment was analyzed by ESCA. Next, the heat-treated fluororesin film was stacked on electrolytic copper foil CF-T9DA-SV-18 (thickness 18 $\mu$m/ Rz 0.85 $\mu$m) (made by Fukuda Metal Foil & Powder Co., Ltd.) so that the surface which had been analyzed was in contact with the copper foil, and the two were bonded by heat pressing using a vacuum heat press (Model: MKP-1000HVWH-S7 made by Mikado Technos Co., Ltd.) at a press temperature of 320°C for a preheating time of 60 seconds at a pressure of 1.5 MPa for a pressing time of 300 seconds. The adhesion strength was measured by peeling at 90° by Tensilon Universal Testing Machine.

(Example 10)

The surface of the film annealed in Example 2 (Sample 2: 180) was analyzed by ESCA and as a result the film has an oxygen element percentage of 8.15 atom%. Furthermore, the film was etched using argon gas cluster ion beams at an incident angle of 45° under sputtering conditions of 2.5 kV $\times$ 10 nA in the direction of depth for 15 minutes. Then the surface of the film was analyzed by ESCA and as a result the film has an oxygen element percentage of 0.88 atom%. The difference between the two results is 7.27 atom%. The adhesion strength between the annealed film and the copper foil is 1.33 N/mm and the adhesion strength between the treated surfaces of the film is 250 N/m. Next, heat treatment was performed at 180°C for 3 minutes, the surface was analyzed and the adhesion strength was measured in the same manner as in Example 9.

(Examples 11 and 12)

Films were evaluated in the same manner as in Example 9 except for using the film annealed in Example 3 (Sample 2: 200) and the film annealed in Example 4 (Sample 3: 180).

(Example 13)

The surface of the film annealed in Example 5 (Sample 4: 180) was analyzed by ESCA and as a result the film has an oxygen element percentage of 2.67 atom%. Furthermore, the film was etched using argon gas cluster ion beams at an incident angle of 45° under sputtering conditions of 2.5 kV $\times$ 10 nA in the direction of depth for 15 minutes. Then the surface of the film was analyzed by ESCA and as a result the film has an oxygen element percentage of 0.90 atom%. The difference between the two results is 1.77 atom%. The adhesion strength between the annealed film and the copper foil is 1.27 N/mm. Next, heat treatment was performed at 180°C for 3 minutes, the surface was analyzed and the adhesion strength was measured in the same manner as in Example 9.

(Example 14)

Heat treatment was performed at 180°C for 3 minutes, the surface was analyzed and the adhesion strength was measured in the same manner as in Example 9 except for using the film annealed in Example 7 (Sample 6: 180).

(Example 15)

Film was evaluated in the same manner as in Example 9 except for using the film annealed in Example 2 (Sample 2: 180) and putting it in an electric oven at 120°C (air atmosphere) and heat treating for 3 minutes.

(Example 16)

Film was evaluated in the same manner as in Example 9 except for using the film annealed in Example 2 (Sample 2: 180) and putting it in an electric oven at 200°C (air atmosphere) and heat treating for 3 minutes.

(Example 17)

Film was evaluated in the same manner as in Example 9 except for using the film annealed in Example 2 (Sample 2: 180) and putting it in an electric oven at 250°C (air atmosphere) and heat treating for 3 minutes.

In Examples 10 and 14, the dielectric constant and the dielectric loss tangent were measured by a split cylinder resonator (10 GHz and 40 GHz).

(Comparative Example 3)

The surface of the film annealed in Example 6 (Sample 5: 180) was analyzed by ESCA and as a result the film has an oxygen element percentage of 1.78 atom%. Furthermore, the film was etched using argon cluster ion beams at an incident angle of 45° under sputtering conditions of 2.5 kV $\times$ 10 nA in the direction of depth for 15 minutes. Then the surface of the film was analyzed by ESCA and as a result the film has an oxygen element percentage of 0.86 atom%. The difference between the two results is 0.92 atom%. Next, heat treatment was performed at 180°C for 3 minutes, the surface was analyzed and the adhesion strength was measured in the same manner as in Example 8.

The results of Examples 9 to 17 and Comparative Example 3 are shown in Table 4.

[Table 4]

| | | | Example 9 | Example 10 | Example 11 | Example 12 | Example 13 | Example 14 | Example 15 | Example 16 | Example 17 | Comparative Example 3 |
|---|---|---|---|---|---|---|---|---|---|---|---|---|
| | | | Sample 1:180 | Sample 2:180 | Sample 2:200 | Sample 3:180 | Sample 4:180 | Sample 6:180 | Sample 2:180 | Sample 2:180 | Sample 2:180 | Sample 5:180 |
| Evaluation before heat treatment (after annealing) | Surface oxygen element percentage (atomic%) | | - | 8.15 | - | - | 2.67 | - | - | - | - | 1.78 |
| | Difference between percentages of oxygen element atomic%) | | - | 7.27 | - | - | 1.77 | - | - | - | - | 0.92 |
| | Adhesion strength | To copper foil (N/mm) | - | 1.33 | - | - | 1.27 | - | - | - | - | - |
| | | Between treated surfaces (N/m) | - | 250 | - | - | - | - | - | - | - | - |
| Heat treatment temperature (°C) | | | 180 | 180 | 180 | 180 | 180 | 180 | 120 | 200 | 250 | 180 |
| Evaluation after heat treatment | Surface oxygen element percentage (atomic%) | | 11.84 | 6.52 | 5.94 | 2.94 | 1.87 | 5.35 | 7.7 | 4.59 | 2.27 | 1.32 |
| | Adhesion strength (N/mm) | | 1.4 | 1.28 | 1.25 | 1.3 | 0.97 | 1.19 | 1.35 | 1.28 | 1.11 | 0.74 |
| | Dielectric constant (10 GHz) | | - | 2.05 | - | - | - | 2.02 | - | - | - | - |
| | Dielectric loss tangent (10 GHz) | | - | 0.00105 | - | - | - | 0.00029 | - | - | - | - |
| | Dielectric constant (40 GHz) | | - | 2.05 | - | - | - | 2.02 | - | - | - | - |
| | Dielectric loss tangent (40 GHz) | | - | 0.00083 | - | - | - | 0.00022 | - | - | - | - |

EP 4 282 906 A1

19

(Comparative Example 4)

Both sides of a 50-μm thick film prepared by melt extrusion by a T-die method in the same manner as for Sample 1 were surface treated by a discharge treatment without using organic compound-containing inert gas. The film was passed through an annealing furnace (in air atmosphere) at 180°C by a roll-to-roll method, cooled in the cooling zone and taken up in the form of a roll. The surface of the film after annealing has an oxygen element percentage of 4.16%. The adhesion strength between the treated surfaces of the film is 28 N/m. Next, heat treatment was performed at 180°C for 3 minutes, the surface was analyzed and the adhesion strength to copper foil was measured in the same manner as in Example 9. The surface of the film after heat treatment has an oxygen element percentage of 0.92% and has an adhesion strength to copper foil of 0.23 N/mm.

The results of Table 4 and Comparative Example 4 show that by setting the oxygen element percentage on the surface of the film after heat treatment at 180°C for 3 minutes to 1.35 atom% or more, an adhesion strength to copper foil of 0.8 N/mm or more can be obtained. The surface treatment using the organic compound-containing inert gas according to the present disclosure is suitably used because deactivation due to heat is small. The above shows that the fluororesin film of the present invention provides sufficient adhesion strength even when the film is bonded after preheating in the step of lamination and the like with copper foil. Furthermore, since the film has a dielectric loss tangent of 0.0015 or less, transmission loss on circuit boards in high frequency regions can be reduced.

(Example 18)

A sample, which was a 50-μm thick film surface-treated on one side, was prepared in the same manner as for Sample 6 using fluorinated PFA (TFE/ PPVE copolymer, composition: TFE/ PPVE = 95.8/ 4.2 (% by mass), MFR: 16.2 g/ 10 minutes, melting point: 305°C, number of unstable terminal groups: cannot be detected (less than 1 per $10^6$ carbon atoms in the main chain). The treated surface has an oxygen element percentage of 10.18% by ESCA surface analysis. The film was annealed and the rate of dimensional change in the MD and the TD directions was measured in the same manner as in Example 7. The film has an absolute value of the rate of dimensional change of 0.90% in MD and 0.58% in TD. Furthermore, the annealed film was put on the metal tray so that the treated surface is in contact with air and heat-treated at 180°C for 3 minutes in the same manner as in Example 14. The treated surface was analyzed by ESCA and as a result, the film has an oxygen element percentage of 6.07%.

Next, the annealed film was bonded to electrolytic copper foil CF-T9DA-SV-18 (thickness 18 μm/ Rz 0.85 μm) (made by Fukuda Metal Foil & Powder Co., Ltd.) by heat pressing using a vacuum heat press (Model: MKP-1000HVWH-S7, made by Mikado Technos Co., Ltd.) at a press temperature of 320°C for a preheating time of 60 seconds at a pressure of 1.5 MPa for a pressing time of 300 seconds. The side of the fluorine film of the resulting single-sided copper-clad laminated board was surface treated. A piece of the single-sided copper-clad laminated board, two pieces of prepreg R-5680 (GN) (thickness 132 μm) (made by Panasonic Corporation) and a piece of the single-sided copper-clad laminated board were stacked in that order so that the treated surface was combined with prepreg, and they were bonded using a vacuum heat press at a press temperature of 200°C to give a double-sided copper-clad laminated board. The adhesion strength between the copper foil and the fluorine film is 13.8 N/cm.

The copper foil of the double-sided copper-clad laminated board prepared was removed and dielectric properties at 20 GHz were measured. As a result, the film has a dielectric constant of 3.03 and a dielectric loss tangent of 0.00208. A sample prepared by pressing only prepreg R-5680 (GN) (thickness 132 μm) (made by Panasonic Corporation) at 200°C has a dielectric constant of 3.31 and a dielectric loss tangent of 0.00244. Furthermore, dielectric properties at 40 GHz were measured and as a result the sample has a dielectric constant of 3.02 and a dielectric loss tangent of 0.00252. A sample prepared by pressing only prepreg R-5680 (GN) (thickness 132 μm) (made by Panasonic Corporation) at 200°C has a dielectric constant of 3.38 and a dielectric loss tangent of 0.00294.

Example 18 shows that combination of the present fluororesin film with other materials improves electric properties of other materials and changing the thickness of the fluororesin film makes it possible to control dielectric properties and other physical properties. Furthermore, since the film has low thermal shrinkage rate and wrinkles are less likely to be formed during winding, few defects are generated when laminating the fluororesin film and copper foil by a roll-to-roll method.

On the whole, the above results of experiment show that in the fluororesin film of the present disclosure, defects in lamination are reduced, and bonding of fluororesin film to highly smooth copper foil, which was difficult in the past, becomes possible. At the same time, the fluororesin film has low dielectric loss tangent. Therefore it has the advantage that transmission loss can be significantly reduced when the laminate with highly smooth copper foil is used as a material of substrate for circuits.

Industrial Applicability

The fluororesin film of the present disclosure can be suitably used for a copper-clad laminated board for a circuit board.

## Claims

1. A fluororesin film that is a film comprising a fluororesin-containing composition,

   wherein an oxygen element percentage as measured when heat treatment is performed at 180°C for 3 minutes and then the state of one or both surfaces of the film is observed by scanning X-ray photoelectron spectroscopy (XPS/ESCA) is 1.35 atom% or more, and
   an absolute value of a rate of dimensional change in MD and TD before and after heat treatment as measured when the film is heat-treated at 180°C for 10 minutes and then cooled to 25°C is 2% or less.

2. The fluororesin film according to claim 1, wherein the oxygen element percentage is 1.5 atom% or more.

3. The fluororesin film according to claim 1 or 2, wherein the fluororesin film comprises tetrafluoroethylene-perfluoroalkyl vinyl ether (PFA) or tetrafluoroethylene-hexafluoropropylene (FEP).

4. The fluororesin film according to any one of claims 1 to 3, wherein a difference between an oxygen element percentage measured when the state of one or both surfaces of the film is observed by scanning X-ray photoelectron spectroscopy (XPS/ESCA) and an oxygen element percentage measured by scanning X-ray photoelectron spectroscopy (XPS/ESCA) after etching the film by argon gas cluster ion beams at an incident angle of 45° in the direction of the depth for 15 minutes is 1.0 atom% or more.

5. The fluororesin film according to any one of claims 1 to 4, wherein one or both surfaces of the fluororesin film have an adhesion strength of more than 30 N/m when the surfaces of the film are mutually bonded at 200°C.

6. The fluororesin film according to any one of claims 1 to 5, wherein the fluororesin film has a dielectric loss tangent at 10 GHz of less than 0.0015.

7. The fluororesin film according to any one of claims 1 to 5, wherein the fluororesin film has a dielectric loss tangent at 40 GHz of less than 0.0015.

8. The fluororesin film according to any one of claims 1 to 7, wherein the number of unstable terminal groups is less than 10 per $10^6$ carbon atoms in a main chain of the fluororesin.

9. The fluororesin film according to any one of claims 1 to 8, wherein the fluororesin film has an adhesion strength of 0.8 N/mm or more when bonded to copper foil having a surface roughness Rz of 1.5 $\mu$m or less.

10. The fluororesin film according to any one of claims 1 to 9, wherein the fluororesin film is used for a copper-clad laminated board.

11. A copper-clad laminate, comprising copper foil and the fluororesin film according to any one of claims 1 to 10 as essential layers.

12. The copper-clad laminate according to claim 11, further comprising a layer other than the copper foil or the fluororesin film,
    wherein the layer other than the copper foil or the fluororesin film is at least one selected from the group consisting of polyimide, liquid crystal polymer, polyphenylene sulfide, a cycloolefin polymer, polystyrene, epoxy resin, bismaleimide, polyphenylene oxide, polyphenylene ether and polybutadiene.

13. The copper-clad laminate according to claim 11 or 12, wherein the copper foil has a surface roughness Rz of 1.5 $\mu$m or less.

14. The copper-clad laminate according to any one of claims 11 to 13, wherein the copper-clad laminate has an adhesion strength between the copper foil and the fluororesin film of 0.8 N/mm or more.

15. A substrate for circuit, comprising the copper-clad laminate according to any one of claims 11 to 14.

16. A method for producing the copper-clad laminate according to any one of claims 11 to 15, comprising preheating a fluororesin film at the glass transition temperature or more and less than the melting point of the film, and then bonding the film to copper foil and/or a substrate other than the copper foil or the fluororesin.

## INTERNATIONAL SEARCH REPORT

| International application No. |
|---|
| **PCT/JP2022/001979** |

**A. CLASSIFICATION OF SUBJECT MATTER**

*C08J 5/18*(2006.01)i; *B32B 15/01*(2006.01)i; *B32B 15/08*(2006.01)i; *B32B 15/082*(2006.01)i; *H05K 1/03*(2006.01)i; *C08J 7/00*(2006.01)i

FI: C08J7/00 301; C08J7/00 306; B32B15/08 J; B32B15/01 H; B32B15/08; H05K1/03 610H; H05K1/03 630H; B32B15/082 B; C08J7/00 CEW; C08J5/18

According to International Patent Classification (IPC) or to both national classification and IPC

**B. FIELDS SEARCHED**

Minimum documentation searched (classification system followed by classification symbols)

C08J5/18; B32B15/01; B32B15/08; B32B15/082; H05K1/03; C08J7/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2016/021666 A1 (NIPPON KAYAKU KK) 11 February 2016 (2016-02-11) claims, paragraphs [0002], [0004], [0036], [0041]-[0042], table 1 | 1-16 |
| Y | WO 2019/203243 A1 (AGC INC) 24 October 2019 (2019-10-24) claims, paragraphs [0008], [0087]-[0088], [0090], table 1 | 1-16 |
| P, A | CN 112300426 A (GUANGDONG ANDELI NEW MATERIAL CO., LTD.) 02 February 2021 (2021-02-02) | 1-16 |
| A | JP 2013-139578 A (DAIKIN INDUSTRIES LTD) 18 July 2013 (2013-07-18) | 1-16 |

☐ Further documents are listed in the continuation of Box C.   ☑ See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **18 March 2022** | **29 March 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

INTERNATIONAL SEARCH REPORT
Information on patent family members

International application No.

**PCT/JP2022/001979**

| Patent document cited in search report | | | Publication date (day/month/year) | Patent family member(s) | | | Publication date (day/month/year) |
|---|---|---|---|---|---|---|---|
| WO | 2016/021666 | A1 | 11 February 2016 | US 2017/0231088 A1 claims, examples KR 10-2017-0041725 A CN 106664806 A | | | |
| WO | 2019/203243 | A1 | 24 October 2019 | US 2020/0407524 A1 claims, examples CN 111989358 A KR 10-2021-0003084 A | | | |
| CN | 112300426 | A | 02 February 2021 | (Family: none) | | | |
| JP | 2013-139578 | A | 18 July 2013 | US 2011/0073167 A1 WO 2009/142259 A1 EP 2284213 A1 CN 102027050 A | | | |

Form PCT/ISA/210 (patent family annex) (January 2015)

**EP 4 282 906 A1**

**Patent documents cited in the description**

- WO 2016021666 A
- WO 2019203243 A
- WO 2020145133 A